# EUROPEAN PATENT APPLICATION

(11) **EP 2 887 388 A1**
(43) Date of publication of application: **24.06.2015**
(21) Application number: 14195924.7
(22) Date of filing: 02.12.2014
(51) Int. Cl.: H01L 23/00, H01L 25/16

(54) **Integrated optoelectronic module**

(30) Priority: 03.12.2013 US 201361910978 P
(71) Applicant: Forelux Inc., Taipei City 10059 (TW)
(72) Inventor: Chen, Shu-Lu, 10059 Taipei City, (TW)
(74) Representative: 2K Patentanwälte Blasberg Kewitz & Reichel

(57) **Abstract**

An integrated module includes a first component (200) having a photonic device (202) and electrical pads (220) at a first side and a second side opposite to the first side, and a second component (300) having electrical pads (320) and bonded to the first component (200) by matching their electrical pads. An optical signal is incident from an external medium to the photonic device (202) through an anti-reflection coating (255) at the second side of the first component, a partially-etched opening (250), or an etch-through opening (308). The opening (255) can either be in the first component (200) so the optical signal is incident at the photonic device (202) from the second side or the opening (308) can be in the second component (300) so the optical signal is incident at the photonic device (202) through part of the second component (300). When bonding the first component to the second component, a protrusion and indentation pair (260, 360) can be used to increase the alignment accuracy.

## Description

### CROSS-REFERENCE TO RELATED APPLICATIONS

This patent application claims the benefit of United States Provisional Patent Application No. 61/910,978, filed on December 3, 2013, which are incorporated by reference herein.

### BACKGROUND

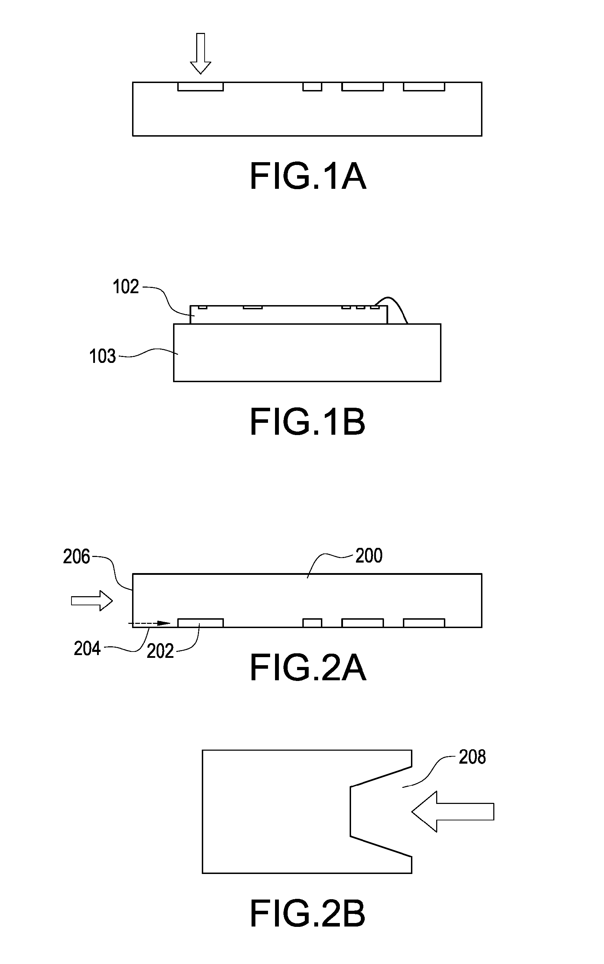

For optoelectronic devices, optical coupling has always been a major issue. As shown in Fig. 1A, the related-art optical device (optoelectronic) usually couples light directly from above the optical device, with optical lens (not shown) to focus beam onto the device.

Optoelectronic devices, like most electronic devices, are usually near the top surface of the wafer; hence coupling from top surface is the conventional way. But since optoelectronic signals require high bandwidth, flip-chip bonding, due to its tight pitch capability and more reliability, gradually becomes the preferred way compared to conventional wire-bonding, especially at higher data rate. However, since conventional semiconductor fabrication processes both electronic devices and optical devices near the top surface of the wafer, optical coupling path will be blocked if the metal pads are flip-chip bonded onto another chip. Hence, wire-bonding is usually used as shown in Fig. 1B wherein wire-bonding is used to transfer the electrical signals from photonic IC 102 to a substrate 103.

### SUMMARY

According to one innovative aspect of the subject matter described in this specification, an integrated module comprises a first component having a photonic device and electrical pads at a first side and an anti-reflection coating layer at a second side opposite to the first side, a second component having electrical pads at a first side and a second side opposite to the first side, an optical signal is incident from an external medium at the second side of the first component, wherein the first side of the first component is bonded to the first side of the second component by aligning at least one of the electrical pad from each component.

According to another innovative aspect of the subject matter described in this specification, an integrated optoelectronic module comprises a first component having a photonic device and electrical pads at a first side and a second side opposite to the first side, a second component having electrical pads at a first side and a second side opposite to the first side, an optical signal is incident from an external medium at the first side of the first component, wherein the first side of the first component is bonded to the first side of the second component and the area above the photonic device of the first component is exposed to provide an open area and not covered by the second component.

According to another innovative aspect of the subject matter described in this specification, a method of forming an integrated module comprises forming a surface protrusion structure and a first electrical pad on a first semiconductor substrate, forming a surface indentation structure and a second electrical pad on a second semiconductor substrate, disposing the first semiconductor substrate over the second semiconductor substrate by substantially matching the protrusion structure to the indentation structure and aligning the first electrical pad to the second electrical pad, applying chemical or physical force including heating, pressure or their combination to form bonding between the first semiconductor substrate and the second semiconductor substrate.

The details of one or more implementations are set forth in the accompanying drawings and the description below. Other potential features and advantages will become apparent from the description, the drawings, and the claims.

### BRIEF DESCRIPTION OF THE DRAWINGS

Fig. 1A and 1B show the related art packaging scheme for optoelectronic devices.
Fig. 2A shows the side view of optoelectronic integrated circuit (IC), and Fig. 2B shows a top view of Fig. 2A.
Fig. 3 shows another example for optoelectronic devices with side coupling wherein a Si interposer is used.
Fig. 4A shows a perspective view of packaging scheme, and Fig. 4B shows a side view of example in Fig. 4A.
Figs. 5A and 5B show the side view of a packaging scheme according to another example.
Figs. 6A, 6B and 6C show the side views of packaging schemes according to still other examples.
Fig. 7 shows side view of packaging scheme according to another example, where there is no TSV.
Figs. 8A and 8B show side views of packaging schemes according to other examples, where the electronic IC includes TSV.
Figs. 9A and 9B show side view of packaging scheme according to other examples, where the electronic IC has open area to expose the optical coupling region of the optoelectronic IC below.
Figs. 10A and 10B show side views of packaging schemes according to other examples.
Fig. 11A shows side view of integrated optoelectronic module according to another example, and Fig. 11B shows the perspective view of the example shown in Fig. 11A. Fig. 11C shows side view of integrated optoelectronic module according to another example similar to Fig. 11A.
Figs. 12A-12D show the sectional views of method for fabricating an optoelectronic IC with O-TSV according to one implementation of the present invention.
Figs. 13A-13E show the sectional views of method for fabricating an optoelectronic IC with OTSV according to another implementation of the present invention.
Figs. 14A-14G show the sectional views of method for fabricating an optoelectronic IC with OTSV according to another implementation of the present invention.
Figs. 15A and 15B show the side views of integrated optoelectronic module with OTSV and Fig. 15C shows the side view of an integrated optoelectronic module according to another example without OTSV.
Figs. 16A and 16B show the side views of integrated optoelectronic modules with OTSV. Figs. 16C to 16F show side views of integrated optoelectronic modules according to other examples either with or without OTSV.
Fig. 17a, 17B and 17C show the exemplary illustrations of 3D alignment mark to enhance the alignment accuracy during bonding process according to this disclosure.

Like reference numbers and designations in the various drawings indicate like elements. It is also to be understood that the various exemplary implementations shown in the figures are merely illustrative representations and are not necessarily drawn to scale.

### DETAILED DESCRIPTION

In this disclosure, an optoelectronic IC is defined as a chip with at least one photonic device such as a photodetector, sensors, Laser, optical modulator, waveguide, or coupler. Electronic devices such as transistors or Microelectromechanical systems (MEMs) based structure such as position tuners for fiber alignment can also be included in the optoelectronic IC, but it is not mandatory for it to be defined as an optoelectronic IC in this disclosure. On the other hand, an electronic IC is defined as a chip with at least one electronic device such as a CMOS transistor or a BJT. It can also include multiple intellectual property circuit blocks such as HDMI controller (PHY or/and MAC layer), USB controller (PHY or/and MAC layer), trans-impedance amplifier, equalizer, DSP unit, power management unit, PCIe controller(PHY or/and MAC layer), wireless connection circuit blocks such as WiFi, Bluetooth, Zigbee, 4G/5G and their successors. In other words, an electronic IC can be a highly integrated circuit which acts to transform the raw electrical signals (after converted from optical signal by the optoelectronic IC) into a variety of commonly used wire or wireless connection protocols. Note that based on this definition, an optoelectronic IC has a broader definition than the electronic IC since an optoelectronic IC can also have all the function circuit blocks in the electronic IC as mentioned before.

Fig. 2A shows the side view of optoelectronic integrated circuit (IC) 200. Fig. 2B shows the top view of the optoelectronic IC 200.

One conventional way to separate optical signals from electrical signals is to couple light through the "side" of the chip as shown in the Fig. 2A. In order to do so, the optoelectronic wafer needs to be diced into several chips after fabrication, and the side of each chip also needs to be polished into optical facet and usually gets coated by an anti-reflection layer. Afterward, the light can be coupled into the optoelectronic IC 200 from fiber (not shown) to the entrance of the waveguide 204, located on the polished side 206. Note that for this packaging scheme, light is usually not directly coupled into an active photonic device , (ex: photodetector or laser), but through passive photonic device such as a waveguide 204 (ex: silicon or III-V materials slot waveguide). The advantage of side coupling is that the overall height of the packaging could be small. Moreover, as shown in Fig. 2B (top view), a cut-out region 208 can be defined on the light entrance side of the optoelectronic IC 200 to facilitate the fiber alignment. For other coupling methods which will be described in the following paragraphs, light can be coupled either directly into the active photonic device (ex: normal incidence) or light can also be coupled into a waveguide, and then guided into the active device like the side-coupling scenario.

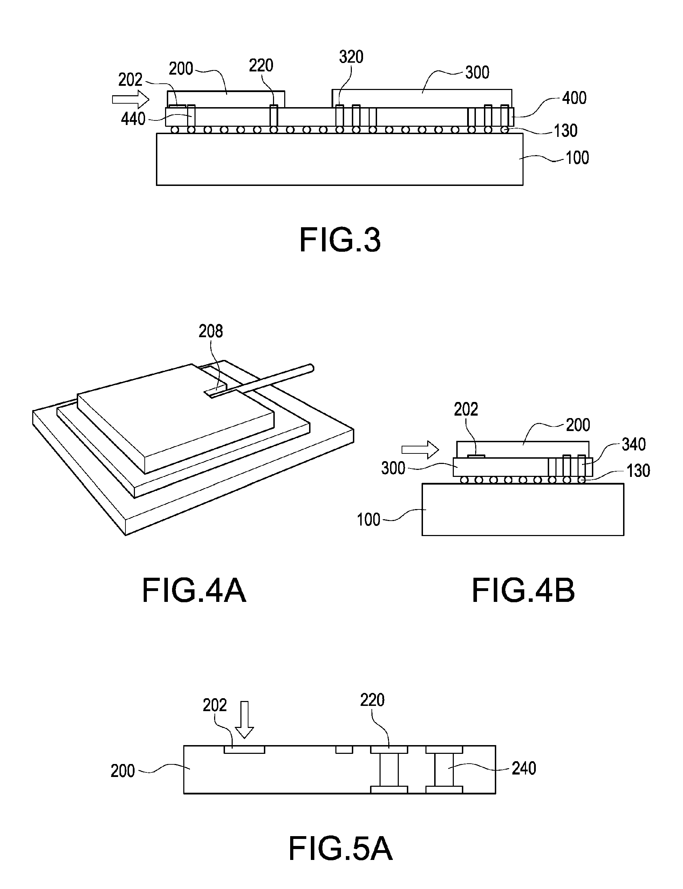

Fig. 3 shows another side-coupling packaging scheme using interposer with TSV (Through Silicon Via). The optoelectronic IC 200 with photonic device 202 (such as photodetector) is mounted on an interposer 400 with TSV 440. An electronic IC 300 is also mounted on the interposer 400 and is, for example, coplanar with the optoelectronic IC 200. The optoelectronic IC 200 and the electronic IC 300 have, on their mounting side, electrical pads 220 and 320 electrically connected to TSV 440. The interposer 400 is mounted on a substrate 100 through solder balls 130 or other bonding mechanisms, and the TSV 440 is electrically connected to respective solder ball 130. The light is incident from a polished side of the optoelectronic IC 200 and propagates to the photodetector 202 through a waveguide (not shown). The photodetector 202 generates electric signal corresponding to the received light and the electric signal is sent to the electronic IC 300 through an electric path in the interposer 400.

Fig. 4A shows a perspective view of another side-coupling packaging scheme. In comparison with the example shown in Fig. 3, the TSV is in the electronic IC instead of in the interposer and the optoelectronic IC 200 is directly flip-chip bonded to the electronic IC 300. Fig. 4B shows the side view corresponding to Fig. 4A. An optoelectronic IC 200 with photonic device 202 (such as photodetector) is mounted on an electronic IC 300 (such as a transimpedance amplifier, TIA) with TSV 340. The TIA 300 is further mounted on a substrate 100 through solder balls 130 or other bonding mechanisms such as cupper pillars. The light is incident from a polished side of the optoelectronic IC 200 and propagates to the photodetector 202 through a waveguide (not shown). The photodetector 202 generates electric signal corresponding to the received light and the electric signal is sent to the electronic IC 300 directly. Moreover, as shown in Fig. 4A, a cut-out 208 is defined on light entrance face of the optoelectronic IC 200 to facilitate the alignment and coupling of optical fiber. Using TSV in the electronic IC can eliminate the interposer to achieve a smaller form factor at the expense of potentially higher cost to fabricate the electronic IC, since extra TSV processes need to be performed. Hence the design choice depends on the requirement for performance and the yield of the collaborating foundry producing the electronic IC.

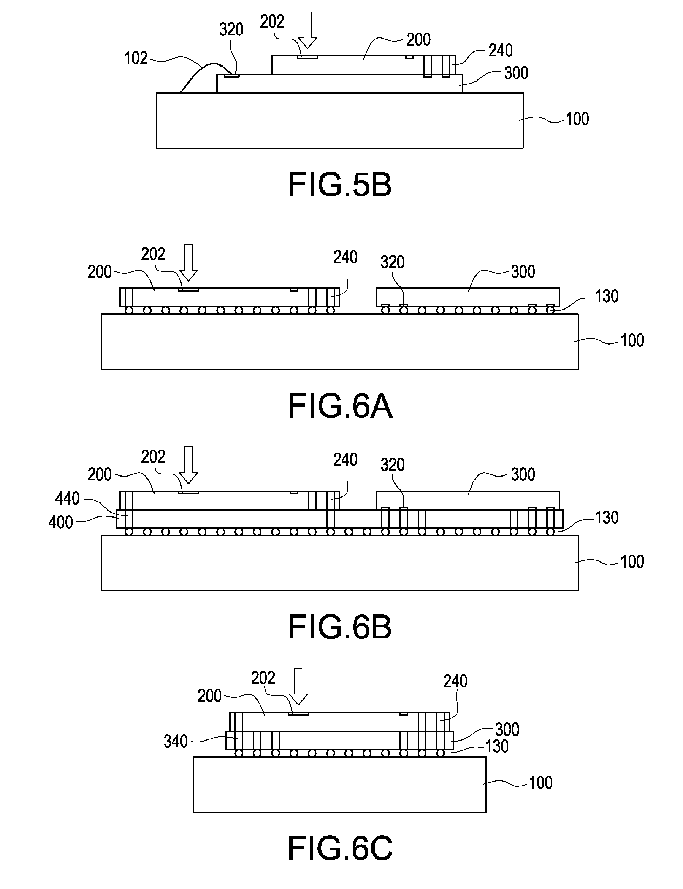

Figs. 5A and 5B show the side views of packaging schemes according to another light coupling scenario: front side normal incidence (front side is defined as the side closer to the optoelectronic device). As shown in Fig. 5A, the optoelectronic IC 200 comprises photonic device 202 (such as photodetector) at a first side thereof and further comprises TSV 240 extended through the first side (front side) and a second side (back side) opposite to the first side. As shown in Fig. 5B, this optoelectronic IC 200 can then be mounted on an electronic IC 300 through ways such as flip-chip bonding. The electronic IC 300 is arranged on a substrate 100 and electrically connected to the substrate 100 through electrical pad 320 using wire-bonding 102. In this packaging scheme, light is incident from a direction substantially vertically to the first side and incident into the photonic device 202. In some implementations, the photonic device 202 is a photodetector, and it generates electric signal corresponding to the received light and the electric signal is sent to the underlying electronic IC 300 through TSV 240. In this example, since the most sensitive signal path is from the optoelectronic IC 200 to the electronic IC 300, flip-chip bonding is used between these two chips. Then the less sensitive signals, which are usually amplified and filtered in the electronic IC 300 (such as TIA), can be coupled into the substrate 100 (such as PCB) using wire-bonding 102.

Figs. 6A, 6B and 6C show the side views of front side normal incidence packaging schemes according to still other examples. As shown in Fig. 6A, an optoelectronic IC 200 comprises a photonic device 202 (such as photodetector) at a first side (front side) thereof and further comprises TSV 240 extended through the first side to a second side opposite to the first side. The optoelectronic IC 200 is arranged on a substrate 100 though solder balls 130 or other bonding mechanisms such as AuSn or Au stub, and the TSV 240 is also electrically connected to respective solder ball 130. An electronic IC 300 (such as a transimpedance amplifier, TIA) is also arranged on the substrate 100 though solder balls 130 and coplanar with the optoelectronic IC 200. The electronic IC 300 has electrical pads 320 corresponding to the solder ball 130. Light is incident from a direction substantially vertically to the first side and incident into the photonic device 202. In some implementation, the photonic device 202 is a photodetector, and it generates electric signal corresponding to the received light and the electric signal is sent to the TIA through an electrical path constituted by the TSV 240, the solder balls 130 and the electrical pads 320. In this example, both the optoelectronic IC 200 and the electronic IC 300 can be flip-chip bonded onto the substrate 100 without using wire-bonding, but this scheme requires more area, hence has larger form factor. Also, adding TSV in the optoelectronic IC 200 might reduce its yield and the high speed performance of TSV also needs to be verified.

As shown in Fig. 6B, the packaging scheme according to still another example further comprises an interposer for mounting an optoelectronic IC 200 and an electronic IC 300. The interposer 400 is used as a low-cost bridge between the optoelectronic IC 200 and the electronic IC 300 and the substrate 100. Compared with Fig. 6A, this interposer 400 is used to bridge the relative fine pitch pads (ex: <50um) on the ICs (the optoelectronic IC 200 and/or the electronic IC 300) into relatively large pitch pads (ex: >50um) on the substrate 100 (ex: PCB). The interposer 400 basically has finer pitch on the side connecting with the ICs, and fans out the electrical signals in its inner stacks and routings 440 before making connections to the substrate with larger pitch.

As shown in Fig. 6C, another front side normal incidence packaging scheme is shown. Compared to previous cases, this one has a compact form factor but the requirement of TSVs on both optoelectronic IC and electronic IC, which might increase the fabrication difficulty and hence reduce the yield of both chips. However, the overall performance could be better due to shorter interconnect distance with flip-chip bonding. The electronic IC can also transform finer pitch on the optoelectronic IC side to a larger pitch on the substrate side if needed. Generally speaking, adding TSV on both ICs (optoelectronic and electronic) might cause the yield to degrade, but it also helps to achieve a smaller form factor and better signal coupling. Hence, this is also a design choice depending on the individual designer's considerations between cost and performance.

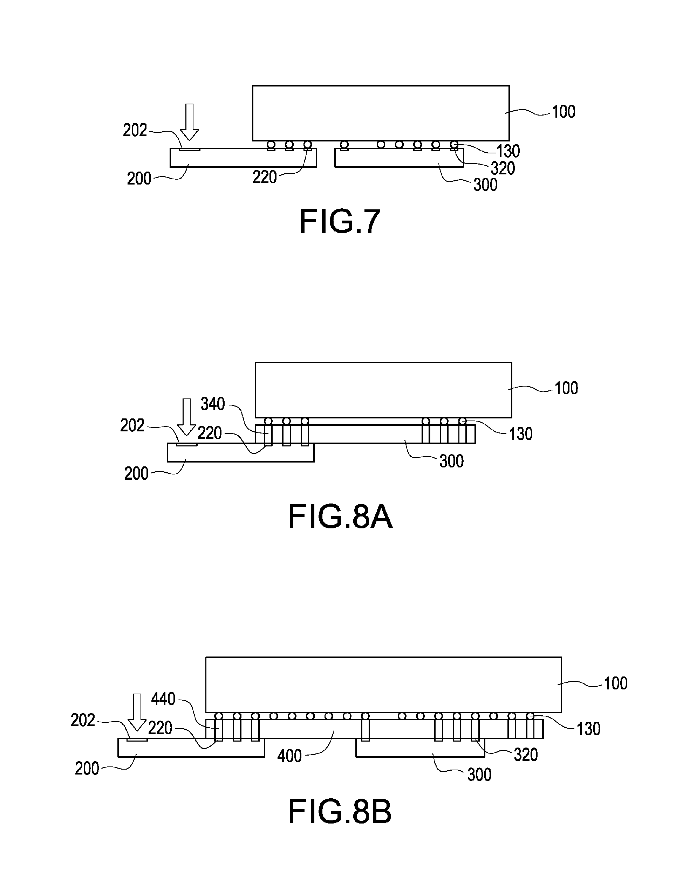

Fig. 7 shows side view of another front side normal incidence packaging scheme wherein the optoelectronic IC 200 does not need TSV for flip-chip bonding. In Fig. 7, an optoelectronic IC 200 having a photonic device 202 (such as photodetector) and electrical pads 220 is hung on a substrate 100 through solder balls 130 wherein the region directly above the photonic device is exposed for fiber coupling. Moreover, an electronic IC 300 (such as TIA) with electrical pads 320 is also hung on the substrate 100 through solder balls 130. The electronic IC 300 is, for example, coplanar with the optoelectronic IC 200. Light is incident from a direction substantially vertically to the side on which the photonic device 202 is arranged. In some implementation, the light is incident into the photodetector 202 and the photodetector 202 generates electric signal corresponding to the received light. The electric signal is sent to the TIA 300 through an electrical path constituted by the electrical pads 220 of the optoelectronic IC 200, the solder balls 130, the substrate 100 and the electrical pads 320 of the electronic device 300.

Figs. 8A and 8B show side views of front side normal incidence packaging schemes according to other examples. In Fig. 8A, an optoelectronic IC 200 having a photonic device 202 (such as photodetector) and electrical pads 220 is hung on an electronic IC 300 (such as TIA) through boding pads and the region directly above the photonic device is exposed for fiber coupling. The electronic IC 300 comprises TSV 340 electrically connected to the electrical pads 220 of the optoelectronic IC 200 and the substrate 100.

In Fig. 8B, an optoelectronic IC 200 having a photonic device 202 (such as photodetector) and electrical pads 220 is hung on an interposer 400 with TSV 440. The interposer 400 is further hung on a substrate 100 through solder balls 130. An electronic IC 300 (such as TIA) having electrical pads 320 is bonded to the interposer 400 and is preferably coplanar with the optoelectronic IC 200. Compared to Fig. 8A, no TSV is required in the electronic IC and the optoelectronic IC and both can be flip-chip bonded to the interposer 400 for higher data rate application. Light is incident from a direction substantially vertically to the side on which the photonic device 202 is arranged. In some implementations, the light is incident into the photodetector 202 and the photodetector 202 generates electric signal corresponding to the received light. The electric signal is sent to the TIA 300 through an electrical path constituted by the electrical pads 220 of the optoelectronic IC 200, the TSV and internal routings 440 of the interposer 400 and the electrical pads 320 of the electronic IC 300.

A fundamental issue of optoelectronic IC coupling is that the optical signal and electrical signal are usually at the same side. Hence, for higher data rate wherein flip-chip bonding is preferred for electrical connection, the optical coupling region needs to be exposed or TSV is needed to route the electrical signal to the other side of the chip. While using over-hang scheme as shown in Figs. 7, and 8A-8B can expose the optical coupling region, it can reduce the overall mechanical robustness. To solve this issue, an optical TSV (OTSV) is described in this disclosure. Several packaging schemes based on this concept are shown in the following figures. There are many differences between conventional TSV and optical TSV. Conventional TSV is for carrying electrical signals or to dissipate heat, so it usually needs to be filled with metal. However, for an optical-TSV (OTSV), whose purpose is to pass light, filling is not mandatory. Moreover, the number of TSV is usually large since many different electrical signals need to be transferred, but the number of OTSV can be very small, since there are usually a lot less optical signals to be transferred compared to electrical signals. Furthermore, TSV needs higher standard for process variation control since electrical signals, especially at high frequency, are sensitive to size variation, but OTSV has relax requirement for process induced size variation. Hence, to separate optical coupling from electrical coupling into different sides for flip-chip purpose, OTSV is easier to process and provides an essential function for high-data rate operation. Two major types of OTSV are described in this disclosure, an etch-through OTSV and a partially etched OTSV.

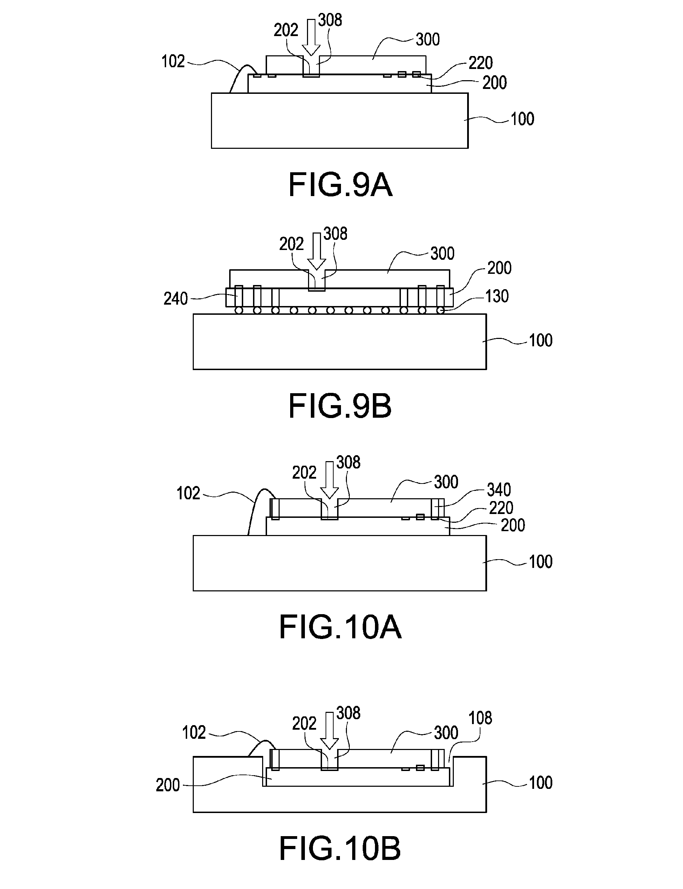

Figs. 9A and 9B show side views of packaging schemes, where the electronic IC 300 (such as TIA) has an etch-through OTSV to expose the optical coupling region of the optoelectronic IC which is flip-chip bonded to the electronic IC 300. In the packaging scheme shown in Fig. 9A, an electronic IC 300 has an OTSV (also referred to as etched through trench) 308 and aligned to the photonic device 202 arranged on an optoelectronic IC 200 with electrical pads 220. The photonic device 202 and the electrical pads 220 of the optoelectronic IC 200 are arranged on a first side of the optoelectronic IC 200, and the optoelectronic IC 200 has a second side opposite to the first side and arranged on a substrate 100. The OTSV 308 of the electronic IC 300 is, for example, defined by lithography and etching process with its radius designed to fit the light coupling apparatus such as an optical fiber. During the flip-chip bonding process, this open area provided by the OTSV 308 is aligned to the photonic device 202 in the optoelectronic IC 200. Before the etching process, a thinning process can optionally be applied to the electronic IC to reduce the height of the chip for easier etching process. Light is incident through the OTSV 308 from a direction substantially vertical to the side on which the photonic device 202 is arranged. In some implementations, the light is incident into the photodetector and the photodetector generates electric signal corresponding to the received light. The electric signal is sent to the substrate 100 through the bonding wire 102, or to the TIA 300 through the electrical pads 220 of the optoelectronic IC 200 and the electrical pads 320 of the TIA 300. The electrical signal can also be routed first to the electronic IC 300, gets amplified and then routed back to the optoelectronic IC for wire-bonding to the substrate.

In Fig. 9B, an electronic IC 300 has an OTSV 308 is arranged on an optoelectronic IC 200 having a photonic device 202 (such as photodetector) and electrical pads 220. The photonic device 202 and the electrical pads 220 of the optoelectronic IC 200 are arranged on a first side of the optoelectronic IC 200, and the optoelectronic IC 200 has a second side opposite to the first side and connected to a substrate 100 through solder balls 130. Compared with Fig. 9A, the optoelectronic IC 200 further has TSV 240 extended between the first side and the second side. The OTSV 308 of the electronic IC 300 is, for example, defined by lithography and etching process, to expose the optical coupling region of the optoelectronic IC 200 below. Light is incident through the OTSV 308 and from a direction substantially vertically to the side on which the photonic device 202 is arranged. In some implementations, the light is incident into the photodetector 202 and the photodetector 202 generates electric signal corresponding to the received light. The electric signal is sent to the substrate 100 through the TSV 240 and the solder balls 130, or to the TIA 300 through the electrical pads 220 of the optoelectronic IC 200 and the electrical pads 320 of the TIA 300. The electrical signal can also be routed first to the electronic IC, gets amplified and then routed back to the optoelectronic IC for flip-chip bonding to the substrate.

Following the previous example, TSV can also be used in the electronic IC instead of in the optoelectronic IC and then wire-bonding can be used to connect the electrical signals from the electronic IC to the substrate. In Fig. 10A, an electronic IC 300 with an OTSV 308 is arranged on an optoelectronic IC 200 having a photonic device 202 and electrical pads 220. The OTSV 308 of the electronic IC 300 is, for example, defined by lithography and etching process, to provide an open area to expose the optical coupling region of the optoelectronic IC 200 below. The electronic IC 300 further comprises TSV 340 electrically connected to electrical pads 220 of the underlying optoelectronic IC 200. The photonic device 202 and the electrical pads 220 of the optoelectronic IC 200 is arranged on a first side of the optoelectronic IC 200, and the optoelectronic IC 200 has a second side opposite to the first side and arranged to a substrate 100. Light is incident through the OTSV 308 from a direction substantially vertically to the side on which the photonic device 202 such as a photodetector, is arranged. In some implementations, the light is incident into the photodetector 202 and the photodetector 202 generates electric signal corresponding to the received light. The electric signal is sent to the substrate 100 through the TSV 340 of the TIA 300 and the bonding wire 102. In some implementations, the photonic device 202 is a Laser, and electrical signal is sent to the laser 202 through the bonding wire 102 and the electronic IC (Laser driver) 300 to control the Laser 202.The wire-bonding distance in the example shown in Fig. 10A can further be reduced by using a recess region 108 on the substrate as shown in Fig. 10B.

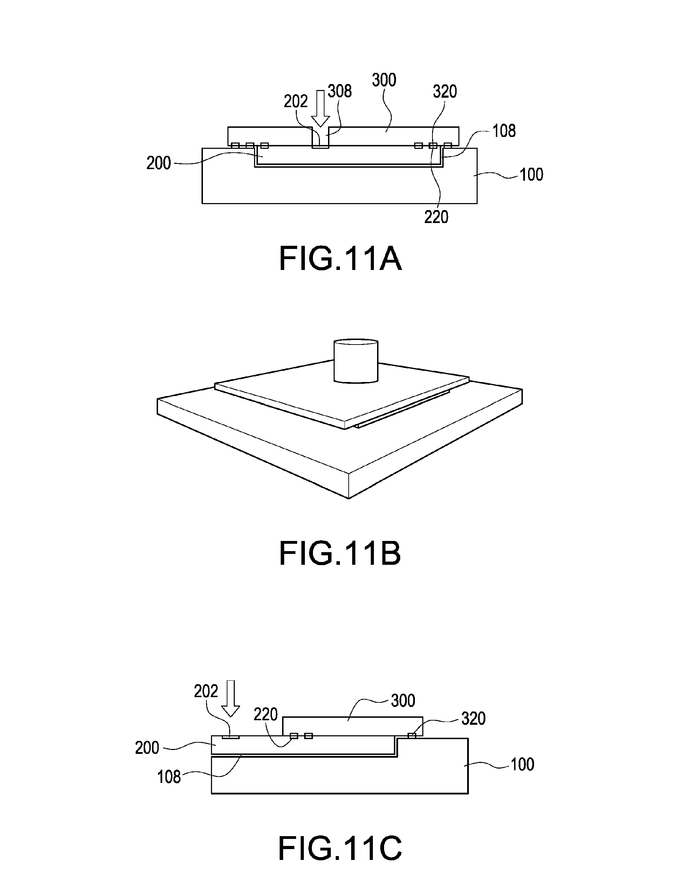

The previous schemes based on an etch-through" OTSV involve either wire-bonding or conventional TSV on one of the IC. Here, we further describe a package scheme using a recessed region on the substrate for the electronic IC to make connection to the substrate using flip-chip bonding. There is no conventional TSV for both optoelectronic IC and electronic IC, and flip-chip bonding can also be used. Fig. 11A shows the side view of this integrated optoelectronic module, and Fig. 11B shows the perspective view of Fig. 11A. In Fig. 11A, an electronic IC 300 having an OTSV 308 is arranged on an optoelectronic IC 200 having a photonic device 202 (such as photodetector or Laser) and electrical pads 220. The OTSV 308 of the electronic IC 300 is, for example, defined by lithography and etching process, to expose the optical coupling region of the optoelectronic IC 200 below. The electronic IC 300 further comprises electrical pads 320 electrically connected to electrical pads 220 of the underlying optoelectronic IC 200 and the substrate 100. The photonic device 202 and the electrical pads 220 of the optoelectronic IC 200 is arranged on a first side of the optoelectronic IC 200, and the optoelectronic IC 200 has a second side opposite to the first side and faces a substrate 100. The optoelectronic IC 200 and the electronic IC 300 arranged thereon are placed in a recess 108 defined on the substrate 100. The recess 108 has such a depth that the electronic IC 300 can be mounted on the substrate 100 with the electrical pads 320 being in contact with the electrical pads of the substrate 100 by means of bonding mechanisms such as solder balls, copper pillars, Au or other mechanisms with an appropriate height, while the optoelectronic IC 200 can be at least partially embedded within the recess 108. Light is incident through the open area provided by OTSV 308 and from a direction substantially vertically to the side on which the photodetector 202 is arranged. In some implementations, the light is incident into the photodetector 202 and the photodetector 202 generates electric signal corresponding to the received light. The electric signal is sent to the electronic IC and then to the substrate. Basically, optoelectronic IC is flip-chip bonded to the electronic IC and the electronic IC is flip-chip bonded to the substrate while no conventional TSV is involved. Note that a light emitting device can also be used for this packaging scenario. For example, the optoelectronic IC includes LED or Laser, and the electronic IC can include driver for the LED or the Laser. The light is emitted from the optoelectronic IC through the OTSV 308.

Moreover, the structure shown in Fig. 11A can be further modified to the one as shown in Fig. 11C. An electronic IC 300 is arranged on an optoelectronic IC 200 having a photonic device 202 (such as photodetector or Laser) and electrical pads 220. The electronic IC 300 further comprises electrical pads 320 electrically connected to electrical pads 220 of the underlying optoelectronic IC 200 and the substrate 100. The photonic device 202 and the electrical pads 220 of the optoelectronic IC 200 is arranged on a first side of the optoelectronic IC 200, and the optoelectronic IC 200 has a second side opposite to the first side and faces a substrate 100. The optoelectronic IC 200 is placed in a recess 108 defined on the substrate 100. The recess 108 has such a depth that the electronic IC 300 can be mounted on the substrate 100 with the electrical pads 320 being in contact with the electrical pads of the substrate 100 while the optoelectronic IC 200 can be at least partially embedded within the recess 108. The region directly above the photonic device 202 is exposed for optical coupling. The electrical signals can be routed between the optoelectronic IC 200 and electronic IC 300 via internal routings and electrical pads 220 and 320, and then connected to the substrate 100 for further processing.

Conventionally, active alignment is mostly used for accurate fiber to device alignment. It requires a machine assisted feedback system to move the fiber around and measure the light coupled into the device at the same time, then fixing the fiber position when the measured signals satisfy a certain threshold level. Such conventional active alignment method is in general an iterative process with relatively low throughput. So a passive alignment method, namely a way for the fiber to be plugged accurately on to the devices without iterative measurement and feedback system, is preferred for mass production. One of the passive methods for a front side normal incidence coupling packaging scenario is to grow thick layer on top of the optoelectronic device and etch a trench to expose the device (ex: photodetector) for the fiber to plug in. However, due to the stress issue, such passivation layer on top of the devices can not be too thick, hence it can only provide limited mechanical support for the fiber (usually with diameter larger than 10um). As a result, for front-side coupling packaging schemes, the practical way is to rely on external module as the mechanical support to stabilize the fiber position, and then attach this external module on to the chip with pins located outside of the devices region where deep holes can be etched into the Si substrate. However, this approach still has no direct alignment between fiber and the optoelectronic device, but only a non-direct alignment, namely from the fiber to the module and then from the module to the optoelectronic device. In the following sections, a direct alignment scheme using partially etched optical TSV(O-TSV) is further described, starting from exemplary fabrication processes.

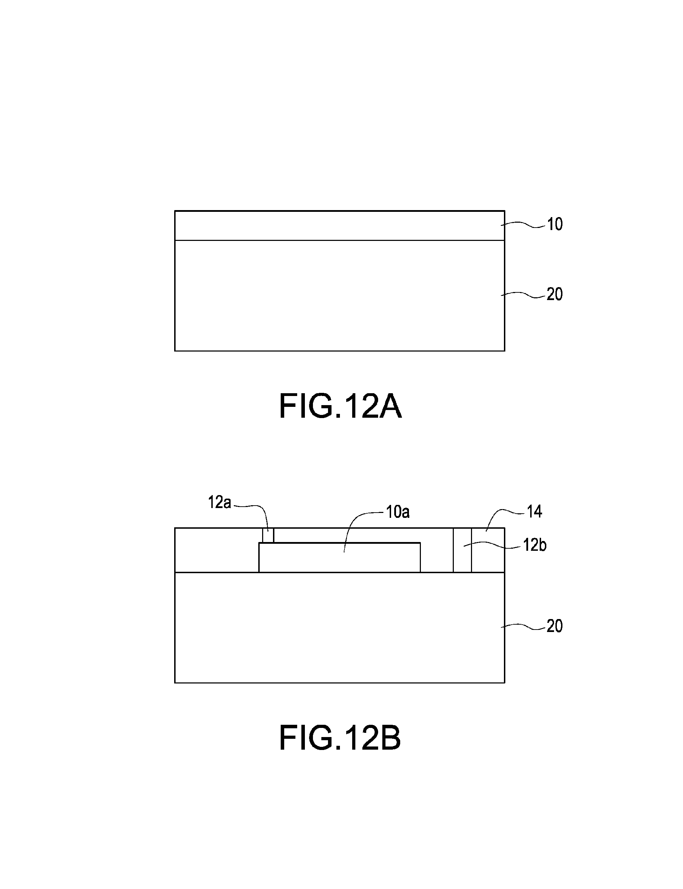

Figs. 12A-12D show the cross-sectional view of methods for fabricating an optoelectronic IC with OTSV according to one implementation of the present invention, where the optical coupling is from back side of the optoelectronic IC. As shown in Fig. 12A, in step S10 starting with a silicon wafer 20, a germanium (Ge) layer 10 can be epitaxially grown on the silicon wafer 20, bonded to the silicon wafer 20, or using other techniques to form on top of the silicon wafer 20.

As shown in Fig. 12B, in step S12, front end of line (FEOL) and back end of line (BEOL) processes are conducted to form a germanium photodetector 10a, such as by patterning a Germanium mesa and the mesa is passivated by a passivation layer 14 and a first contact 12a, a second contact 12b are formed. The first contact (such as electrical pad) 12a provides connection to the germanium photodetector 10a and the second contact 12b provides connection to a face of the silicon wafer 20 after part of the germanium layer 10 is etched away. BEOL process such as metallization, CMP and so on can also be included between step S10 and step S12. In this disclosure, we do not define the exact sequences of such FEOL and BEOL process to form the optoelectronic device since our goal is to describe the essential steps of fabricating an OTSV after most FEOL and BEOL optoelectronic processes.

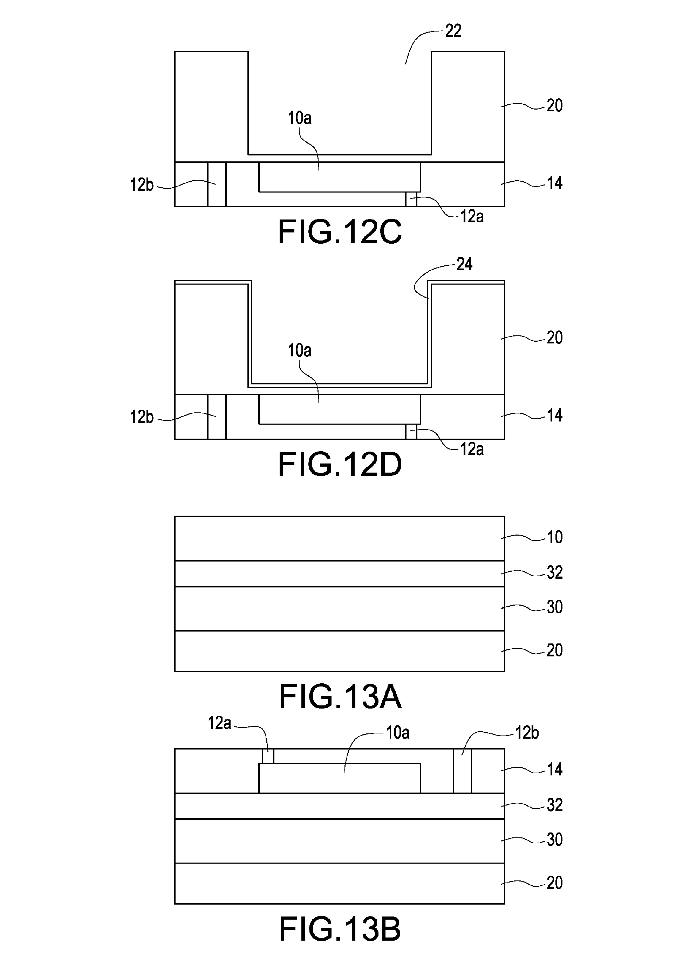

As shown in Fig. 12C, in step S14, the wafer 10 is processed upside down, with back side alignment reference to a front side alignment mark (not shown). The optical coupling region to be formed is now directly "above" the optoelectronic device 10a and is then patterned and etched. The etching process can be dry etch, wet etch or combinations of both. According to one implementation of the present invention, the etching time needs to be well-calibrated to avoid etching into the optoelectronic device region. For example, for a Ge photodetector 10a, an etching process with Ge-to-Si selectivity is preferred. With reference again to Fig. 12C, the portion of the silicon wafer 20 atop the Ge photodetector 10a can function as lens when an optical fiber (external medium) is inserted into the OTSV 22. The thickness of the portion of the silicon wafer 20 atop the Germanium mesa 10a can be, for example, less than 250um. According to another example, the thickness of the portion of the silicon wafer 20 atop the Germanium mesa 10a can be, for example, less than 200um. The OTSV 22 and the silicon wafer 20 together provide a blind trench (blind hole) atop the Ge photodetector 10a. However, from an optical view point, light from the optical fiber can freely propagate to the Ge photodetector 10a through the portion of the silicon wafer 20 atop the Ge photodetector 10a. The OTSV 22 and the silicon wafer 20 effectively function as an optical through hole for coupling the Ge photodetector 10a. After step S14, OTSV 22 is basically formed in the silicon wafer 20. Step S16 is an optional step for better coupling efficiency. As shown in Fig. 12D, in step S16, an optional layer 24 can be deposited for better optical coupling efficiency such as an anti-reflection coating layer or a partial mirror for light to be transmitted into the photonic device. Note that the OTSV 22 not only can couple light into an active photonic device such as Ge photodetector 10a or a Laser as in the previous example, but it can also couple light into a passive device, such as a waveguide, a grating coupler, an AWG, or an Echelle grating for WDM purposes.

Figs. 13A-13E show the cross-sectional view of methods for fabricating an optoelectronic IC with OTSV according to another implementation of the present invention, wherein a SOI wafer is used and the buried oxide layer is used as an etch stop layer. As shown in Fig. 13A, in step S20 starting with a SOI wafer with a silicon substrate 20, an insulator layer 30 and a silicon layer 32. A germanium (Ge) layer 10 can be epitaxially grown on the silicon layer 32, bonded to the silicon layer 32, or using other techniques to form on top of the silicon layer 32.

As shown in Fig. 13B, in step S22, FEOL and BEOL processes are conducted to form a Ge photodetector 10a, such as Ge layer patterning. The Ge layer is etched and passivated to form a first contact 12a, a second contact 12b and a passivation layer 14. The first contact 12a provides connection to the Ge photodetector 10a and the second contact 12b provides connection to a face of the silicon layer 32 after part of the Ge layer 10 is etched away. BEOL process such as metallization, CMP and so on can also be included between step S20 and step S22. In this disclosure, we do not define the exact sequences of such FEOL and BEOL process to form the optoelectronic device since our goal is to describe the essential steps of fabricating OTSV after most FEOL and BEOL optoelectronic processes.

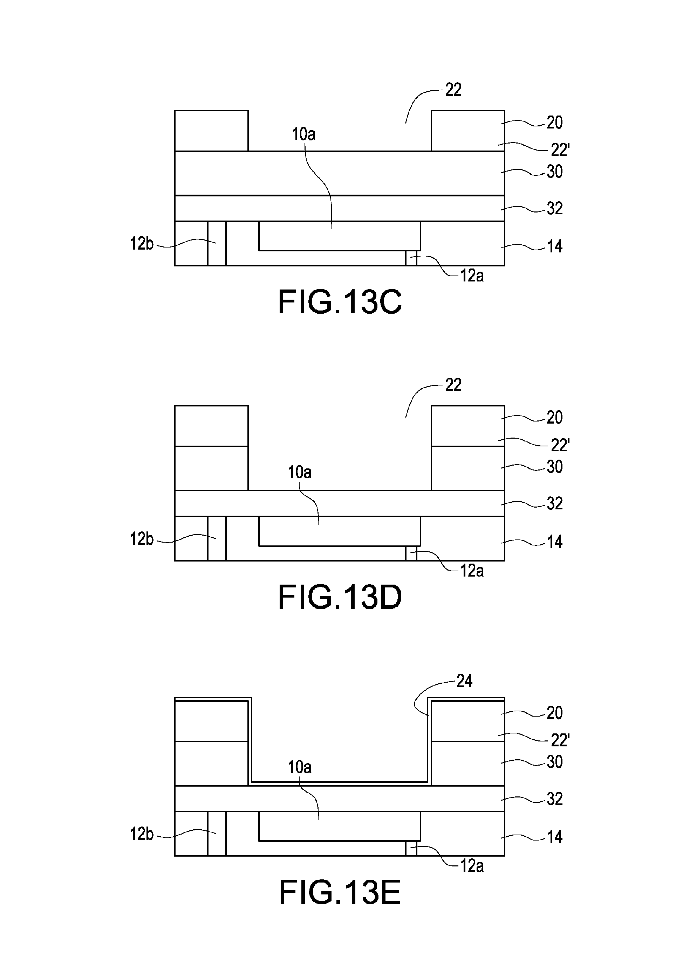

As shown in Fig. 13C, in step S24, the SOI wafer is processed upside down, with back side alignment reference to a front side alignment mark (not shown). The optical coupling region to be formed is now directly "above" the optoelectronic device 10a and is then patterned and etched. The etching process can be dry etch, wet etch or combinations of both. The insulating layer acts as an etching stop layer. An etching process with Si-to-Insulator (oxide or nitride) is preferred.

After step S24, if the thickness of the oxide layer 30 and Si layer 32 is not calibrated to match the condition of the incoming light wavelength, the optical coupling efficiency can still be low. As shown in Fig. 13D, in step S26, an optional second etching can be done to further modify the thickness of the insulating layer 30. (Although a "second" etch is referred, in practice it can be done by the same recipe in the etcher or performed right after the "first" etch in the same etcher chamber.) The etching process can be dry etch, wet etch or combinations of both. For example, a simple wet etching can be used to remove oxide layer 30 without roughing the underneath Si layer 32. If we completely remove the insulator layer 30, another etching cycle can be optionally used to make the Si layer 32 thinner. As mentioned before, the thickness of the insulator layer 30 and Si layer 32 are part of the design parameters and the thickness design choice depend on issues such as incoming light wavelength, material used, etc. Such design choice might affect the performance, but it does not change the essential functionality of this invention. Hence, these choices are part of the "optimization" process based on the concept of this invention and should still be within the scope of this invention. Any variations, derivations from the description above should also be viewed as included in this invention.

As shown in Fig. 13E, after the step S26, an optional layer 24 can be deposited for better optical coupling efficiency such as acting as an anti-reflection coating layer or a partial mirror for light to be transmitted into the device.

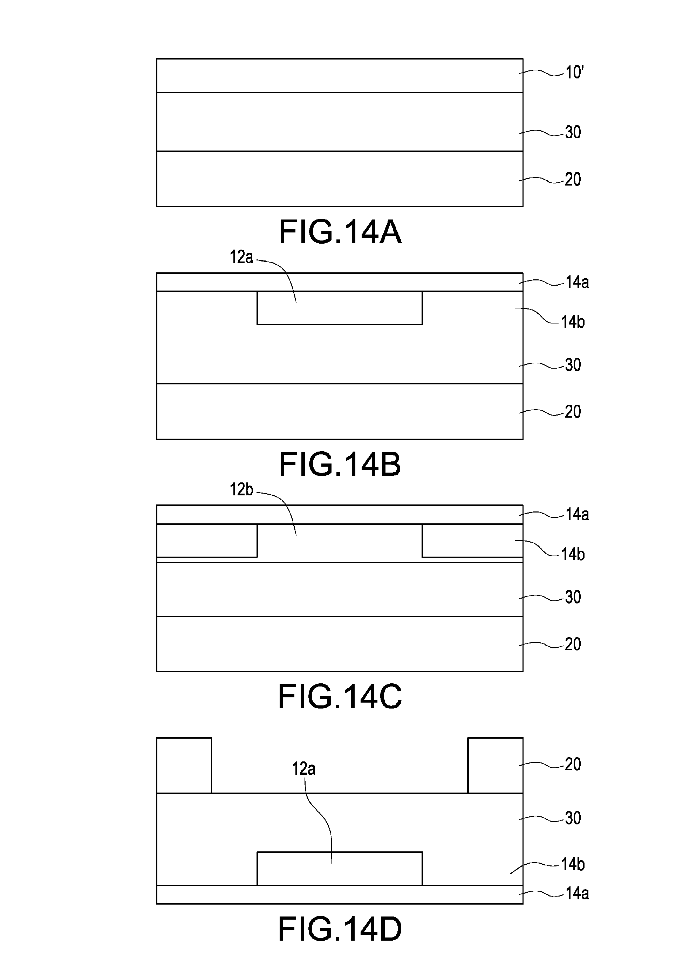

Figs. 14A-14G show the cross-sectional view of methods for fabricating a passive optical device with OTSV according to another implementation of the present invention. As shown in Fig. 14A, in step S30 an SOI wafer with a silicon substrate 20, an insulator layer 30 and a silicon layer 10' is prepared.

As shown in Fig. 14B, in step S32, FEOL and BEOL processes are conducted to form a passive optoelectronic device 12a (ex: Si slot waveguide or grating coupler or 45 degree mirror), including lithography, etch and deposition. BEOL process such as metallization, CMP and so on can also be included between step S30 and step S32. In this disclosure, we do not define the exact sequences of such FEOL and BEOL process to form a Si waveguide and other passive devices since our goal is to describe the essential steps of fabricating an OTSV after most optoelectronic FEOL and BEOL processes. It should be noted that although the first passivation layer 14a and the second passivation layer 14b are drawn as different layers, they can be manufactured with the same material (for example, both are formed with oxide).

As shown in Fig. 14C (S32'), alternatively in step S32, FEOL and BEOL processes are conducted to form another type of Si waveguide (rib waveguide 12b) wherein partial Si is left on both sides of the waveguide. The essential process flows are the same for both types of waveguides after step 32. For simple illustration purpose, we will focus on using Si slot waveguide 12a as the example.

As shown in Fig. 14D, in step S34, the wafer is processed upside down, with back side alignment reference to a front side alignment mark. The optical coupling region is now directly "above" the passive optoelectronic device 12a and can be patterned and etched. The etching process can be dry etch, wet etch or combinations of both. The insulating layer 30 acts as an etching stop layer. An etching process with Si-to-Insulator (oxide or nitride) selectivity is preferred.

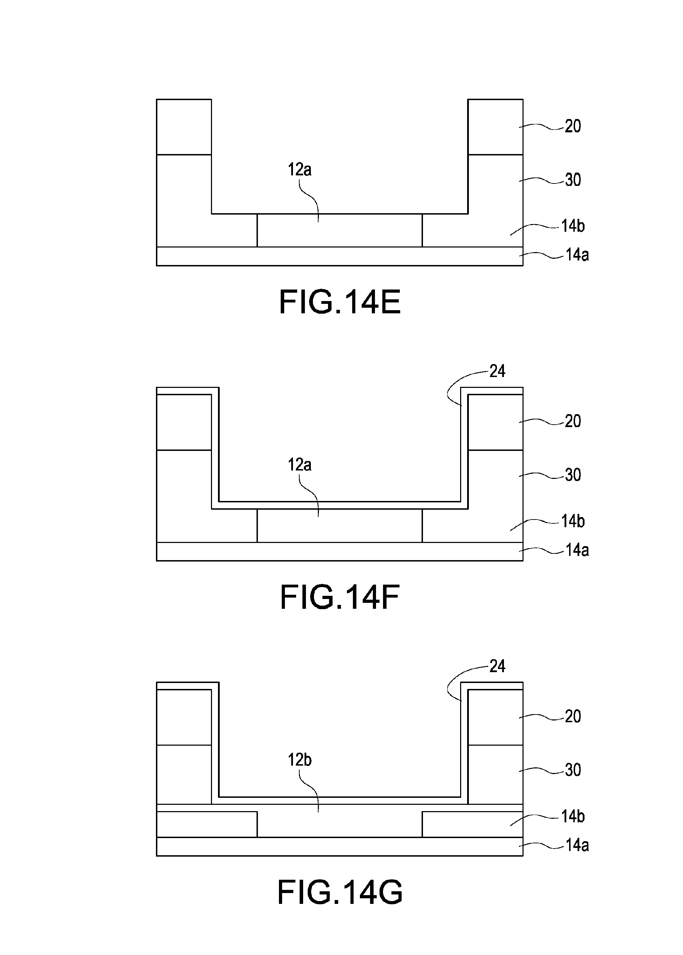

As shown in Fig. 14E, in step S36, a second etching is done to remove the insulating layer 30. (Although we refer to a "second" etch, in practice it can be done using the same recipe in the etcher or performed right after the "first" etch in the same etcher chamber.) The etching process can be dry etch, wet etch or combinations of both. For example, a simple wet etching with BOE can be used to remove oxide layer 30 without roughening the underneath Si layer. Another etching cycle can be optionally used to make the Si waveguide 12a thinner.

As shown in Fig. 14F, in step S38, an optional layer 24 can be deposited on the resulting structure for better optical coupling efficiency or acts as an anti-reflection coating layer or a partial mirror for light to be transmitted into the device. In another implementation, another etching process can be done to form a grating structure or to form a reflective mirror to couple a normal incidence light into the lateral waveguide. Moreover, the relative size of OTSV 22 to the optoelectronic devices 12a could depend on the type of fiber used and the diameter of the devices, hence should not be the limiting factor of this invention. As shown in Fig. 14G (S38'), an alternative type of Si waveguide 12b (rib waveguide) is shown. The essential process flows are very similar for both types of waveguides after step S32 and here shows the corresponding cross-section after step S38.

To summarize, some basic features for an OTSV include using semiconductor process and located at the same chip with at least one optoelectronic devices. The semiconductor process includes lithography to define the OTSV of the optoelectronic device it needs to couple into, and at least one etching process is used to remove Si or other insulating materials.

Furthermore, there are some optional features. For example, there can be an interfacial layer (or layers) or structure (grating/mirror) above the optoelectronic devices for light to be couple into. Such interfacial layer or structure can be anti-reflection coating or partial mirror or grating. After fiber placement, other materials can be used to fill the gap between the unfilled OTSV and the fiber.

One of the important features for OTSV based coupling is that there is no need for the conventional electrical TSV to be used in the relatively expensive optoelectronic IC. Although having both conventional TSV and OTSV on the same IC is still doable, such configuration is not particularly preferred since the overall goal is to separate optical signals with electrical signals into opposite side of the chip, which can be achieved using just either one of them (TSV or OTSV). Also, the area of OTSV can be larger, equal or smaller than the area of the optoelectronic devices it couples to as long as the light can be coupled into the optoelectronic devices through the OTSV. Usually, an OTSV has larger area than the devices since most fibers have diameter larger than 20um and light only travels inside the inner 10's of um core (single mode; for multi-mode, the core can be larger). Hence, the area of the optoelectronic device can be similar to the core of the input fiber, but the area of the OTSV area has to be larger than the fiber in order to accommodate it. However, if a different size of fiber or other light coupling component is used, the size of OTSV can be adjusted accordingly by changing the etching mask. Furthermore, due to practical process condition, the sidewall of an OTSV might not be perfectly straight (ex: tapered from top to the bottom), but such process induced imperfection could be minimized.

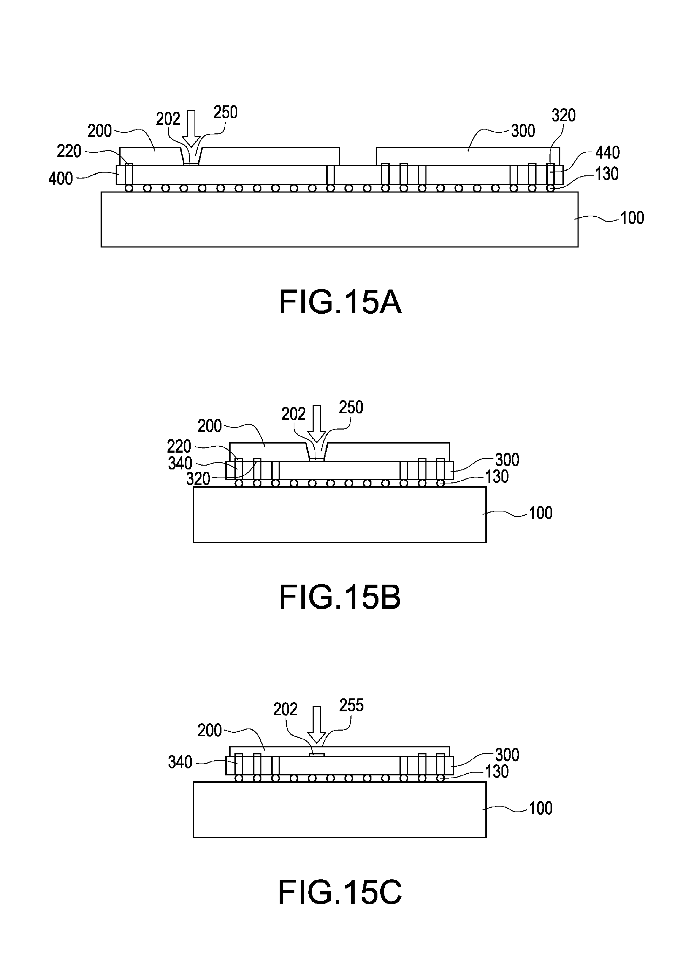

While the previous sections describe some exemplary fabrication processes to form an OTSV wherein the light can be coupled from the back side of the optoelectronic IC, the following sections aim to describe some exemplary packaging schemes based on such partially etched OTSV or based on an anti-reflection coating (ARC) layer on the substrate wherein light is coupled from the back side of the optoelectronic IC. A combination of OTSV and ARC at the backside can also be implemented. Fig. 15A shows the side view of an integrated module having a first component such as an electronic IC 300 and a second component such as an optoelectronic IC 200 wherein the light is coupled to the optoelectronic IC from the back side (back side is defined as the opposite side of which the photonic device 202 is at). To have efficient coupling, the optoelectronic IC can include an OTSV (such as the OTSV formed in the processes shown in Figs. 12A-12D,or Figs. 13A-13E and so on) for the light to incident through, or optoelectronic IC can be polished or grinded to a thinner thickness. In some implementations, the optoelectronic IC can be polished to thinner than 200um or 250um. The integrated module comprisesan optoelectronic IC 200, an electronic IC 300 and an interposer 400. The interposer 400 comprises TSV 440 and can be used as a low-cost bridge between optoelectronic IC 200 and electronic IC 300 and a substrate100. This interposer can "bridge" the relative fine pitch pads on the IC into the relatively large pitch pad on the substrate (ex: PCB). The optoelectronic IC 200 comprises a photonic device 202 (such as photodetector) and electrical pads 220 on a first side thereof. In some implementations, the optoelectronic IC 200 may further comprise an OTSV (partially-etched trench) 250 opened at the second side (back side) opposite to the firs side (front side). The bottom of OTSV 250 is coupled to the photonic device 202. In some implementations without OTSV, an ARC can be applied to the back side of the optoelectronic IC for efficient optical back side coupling. In some implementations, the optoelectronic IC 200 is arranged on the interposer 400 with the electrical pads 220 electrically coupled to the TSV 440. The electronic IC 300 is also arranged on the interposer 400 with the electrical pads 320 thereof electrically coupled to the TSV 440. The interposer 400 is arranged on the substrate 100 through bonding mechanism such as solder balls or cupper pillar 130. In some implementations, an optical fiber (not shown) can be inserted into the OTSV 250 and alighted to the photonic device 202 through the OTSV 250. Light is incident from a direction substantially vertically to the first side and incident into the photonic device 202 either through the OTSV 250 or through an ARC coated Si substrate back side. In some implementations, the photonic device is a photodetector and generates electric signal corresponding to the received light, and the electric signal is sent to the TIA 300 through an electrical path constituted by the electrical pads 220, the TSV and internal routings 440, and the electrical pads 320.

Fig. 15B shows the side view of an integrated module having a first component such as an electronic IC and a second component such as an optoelectronic IC with OTSV. The integrated module comprises an optoelectronic IC 200, and an electronic IC 300 with TSV 340. The optoelectronic IC 200 is stacked on top of the electronic IC 300 with TSV 340, and the electronic IC 300 is electrically connected to an underlying substrate 100 through solder balls 130 or other bonding mechanism such as cupper pillar. The optoelectronic IC 200 comprises a photonic device 202 (such as photodetector) and electrical pads 220 on a first side thereof. The optoelectronic IC 200 further comprises an OTSV (partially-etched trench) 250 opened at the second side opposite to the firs side. The bottom of OTSV is coupled to the photonic device 202, hence making it a back side normal incidence coupling scheme. The electrical pads 220 of the optoelectronic IC 200 are electrically connected to the TSV 340 of the electronic IC 300 when the optoelectronic IC 200 is stacked on top of the electronic IC 300. An optical fiber (not shown) can be inserted into the OTSV 250 and alighted to the photonic device 202 through the OTSV 250. Light is incident from a direction substantially vertically to the first side and incident into the photodetector 202 through the OTSV 250. In some implementations, the photonic device 202 is a photodetector which generates electric signal corresponding to the received light and the electric signal is sent to the electronic IC 300 containing TIA through an electrical path constituted by the electrical pads 220 and the TSV 340. This packaging scheme has tighter form factor compared to Fig 15A since there is no interposer and the conventional TSV and internal routings are on the electronic IC.

In Fig. 15C further shows another implementation with its operation principle similar to fig. 15B except that an ARC layer 255 is used for back side coupling without an OTSV. In some implementations, the optoelectronic IC has a thin thickness, for example thinner than 200um and coated with an ARC for light coupling. In some implementations, the substrate is silicon and it can also act as a lens to converge, diverge or collimate the incident light if it has a different refractive index than the medium of the incident light.

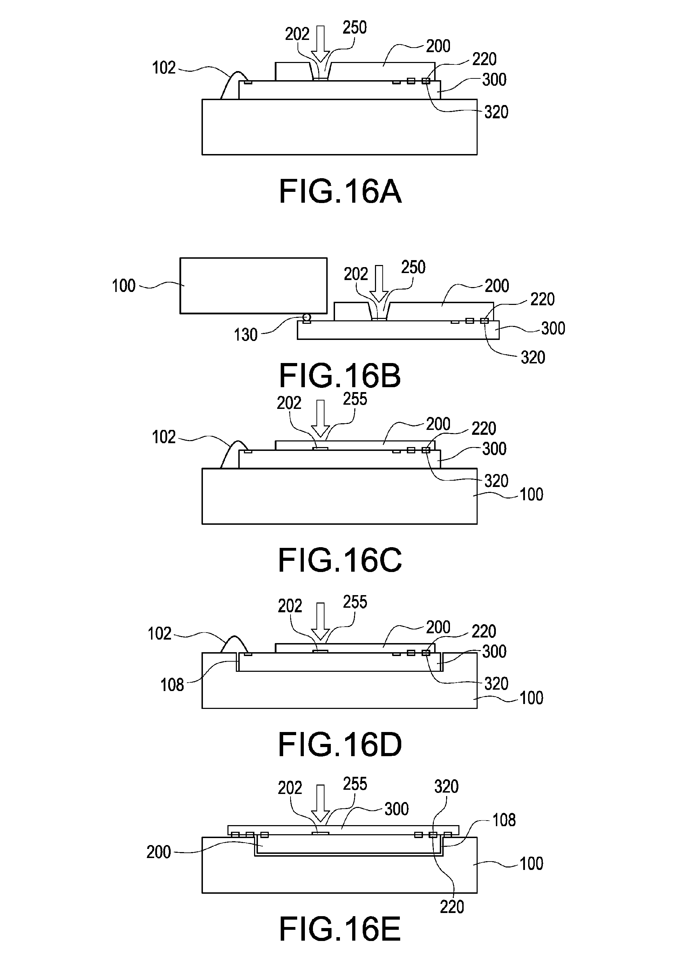

Fig. 16A shows the side view of an integrated module having a first component such as an electronic IC and a second component such as an optoelectronic IC with OTSV. The integrated module comprises an optoelectronic IC 200 with OTSV 250 (partially-etched trench), and an electronic IC 300. The optoelectronic IC 200 with OTSV 250 is stacked on top of the electronic IC 300, and the electronic IC 300 is electrically connected to an underlying substrate 100 with bonding wire 102. The optoelectronic IC 200 comprises a photonic device 202 (such as a photodetector) and electrical pads 220 on a first side thereof. The optoelectronic IC 200 further comprises an OTSV 250 opened at the second side opposite to the firs side. The bottom of OTSV 250 is coupled to the photonic device 202, hence making it a back side normal incidence coupling scheme. The electrical pads 220 of the optoelectronic IC 200 are electrically connected to the electrical pads 320 of the electronic IC 300 either directly as shown in this figure or through other bonding mechanisms such as Electroless nickel immersion gold (ENIG) process, copper pillars or Au stub bump when the optoelectronic IC 200 is stacked on top of the electronic IC 300. An optical fiber (not shown) can be inserted into the OTSV 250 and alighted to the photonic device 202 through the OTSV 250. Compared to the schemes in Fig 15B, no TSV is used in the electronic IC 300 but it requires wire-bonding for the electronic IC to connect to the substrate.

Fig. 16B shows the side view of an integrated module according to another implementation. The integrated module comprises an optoelectronic IC 200 with OTSV (partially-etched trench) 250, and an electronic IC 300. Compared with Fig. 16A, the electronic IC 300 overhangs from the substrate 100 through solder balls 130 and the optoelectronic IC 200 with OTSV 250 is stacked on top of the electronic IC 300. In this packaging scheme, flip-chip bonding can be used for both optoelectronic IC 200 to electronic IC 300 and electronic IC 300 to substrate 100 connections, but the overhangs might cause overall less mechanical robustness. Basically, in the implementations shown in Figs. 16A and 16B, no conventional TSV is needed for electrical signals. In some implementations, the optoelectronic IC in Fig. 16A and 16B can have no OTSV but have ARC at the back side of the substrate for the light to couple through from the back side as shown in the Figs. 16C and 16D.

Fig. 16C shows the side view of an integrated module having a first component such as an electronic IC and a second component such as an optoelectronic IC. The integrated module comprises an optoelectronic IC 200, and an electronic IC 300. The optoelectronic IC 200 is stacked on top of the electronic IC 300, and the electronic IC 300 is electrically connected to an underlying substrate 100 with bonding wire 102. The optoelectronic IC 200 comprises a photonic device 202 (such as a photodetector) and electrical pads 220 on a first side thereof. The electrical pads 220 of the optoelectronic IC 200 are electrically connected to the electrical pads 320 of the electronic IC 300 either directly as shown in this figure or through other bonding mechanisms such as ENIG process, copper pillars or Au stub bump when the optoelectronic IC 200 is stacked on top of the electronic IC 300. In some implementations, the optoelectronic IC 200 can be polished into a thinner thickness, for example thinner than 300um. In other implementations, the substrate is silicon and an ARC layer is on the back side of the substrate and part of the silicon can act as a lens to converge, diverge or collimate the incident light if it has a different refractive index than the incident light medium. The thickness of the silicon substrate can optionally be adjusted to provide sufficient mechanical support or/and appropriate optical length to have the lens effect.

Fig. 16D shows the side view of an integrated module having a first component such as an electronic IC and a second component such as an optoelectronic IC. The implementation shown in Fig. 16D is similar to that shown in Fig. 16C except that the substrate 100 has a recess 108 and at least part of the electronic IC stacked with the 300 optoelectronic IC 200 is embedded into the recess 108. The provision of the recess 108 can advantageously reduce the length of the bonding wire 102.

Fig. 16E shows the side view of an integrated module having a first component such as an electronic IC and a second component such as an optoelectronic IC. The implementation shown in Fig. 16E is similar to that shown in Fig. 11A except that the optoelectronic IC 200 has no OTSV and instead having an ARC at the back side of the IC. In some implementations, the substrate is silicon and it can act as a lens to converge, diverge or collimate the incident light if it has a different refractive index than the incident light medium. The thickness of the silicon substrate can optionally be adjusted to provide sufficient mechanical support or/and appropriate optical length to have the lens effect.

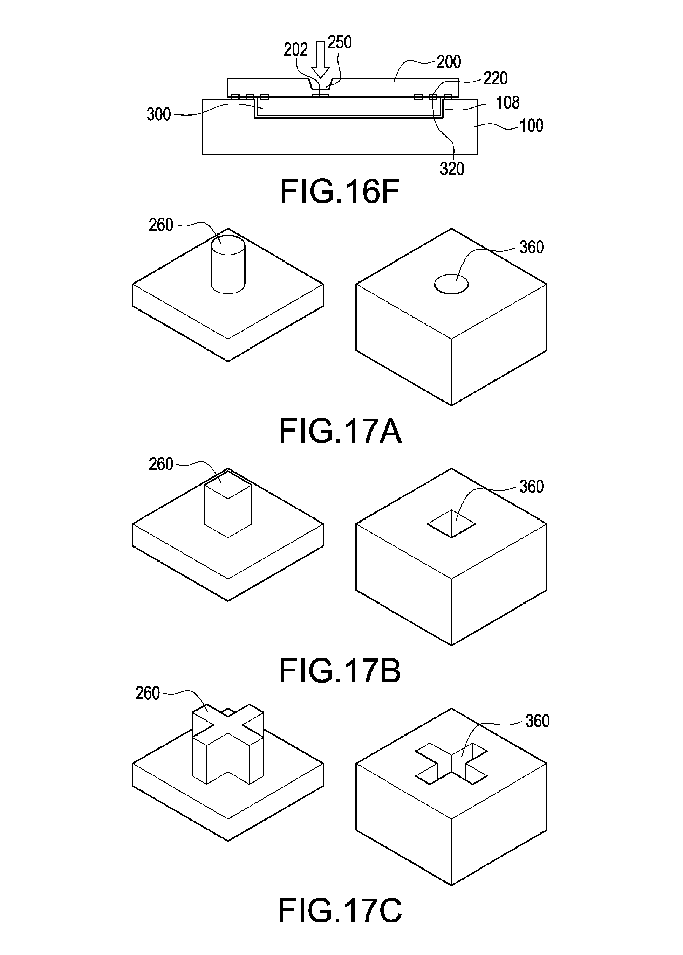

Fig. 16F shows the side view of an integrated module having a first component such as an electronic IC and a second component such as an optoelectronic IC. The integrated module comprises an optoelectronic IC 200 with OTSV 250 (partially-etched trench), and an electronic IC 300. The optoelectronic IC 200 with OTSV 250 is stacked on top of the electronic IC 300. The optoelectronic IC 200 comprises a photonic device 202 (such as a photodetector) and electrical pads 220 on a first side thereof. The optoelectronic IC 200 further comprises an OTSV 250 opened at the second side opposite to the firs side. The bottom of OTSV 250 is coupled to the photodetector 202, hence making it a back side normal incidence coupling scheme. The electrical pads 220 of the optoelectronic IC 200 are electrically connected to the electrical pads 320 of the electronic IC 300 either directly as shown in this figure or through other bonding mechanisms such as ENIG process, copper pillars or Au stub bump when the optoelectronic IC 200 is stacked on top of the electronic IC 300. An optical fiber (not shown) can be inserted into the OTSV 250 and alighted to the photodetector 202 through the OTSV 250. The optoelectronic IC 200 and the electronic IC 300 stack can be placed within a recess 108 of the substrate 100. The recess 108 has such a depth that the optoelectronic IC 200 can be mounted on the substrate 100 with the electrical pads 220 being in contact with the electrical pads of the substrate 100 while the electronic IC 300 can be at least partially embedded within the recess 108.

As mentioned before, there is still alignment issue (direct alignment versus non-direct alignment) in the recessed substrate flip-chip bonding scheme. To mitigate this issue, a 3D alignment method is also described here to increase the alignment accuracy for flip-chip bonding or wafer to wafer bonding. The 3D alignment mark is defined by lithography, etching, CVD film deposition and growth, using the semiconductor process tool. Figs. 17A-17C show the perspective views of different types of 3D alignment marks, and some of the implementations can be regarded as a 3D version of the conventional planar alignment mark. In Fig. 17A, a protrusion structure has circular pillar shape and an indentation structure has corresponding circular recess shape. In Fig. 17B, a protrusion structure has rectangular pillar shape and an indentation structure has corresponding rectangular recess shape. In Fig. 17C, a protrusion structure is cross-shaped pillar and an indentation structure is corresponding cross-shaped recess. Beside the examples shown in Figs. 17A-17C, other shapes for protrusion/indentation pair can also be used as long as it is satisfied the condition of being a 3D protrusion/indentation pair, namely both structures are formed using semiconductor processes such as lithography, etching, CVD film deposition and growth, with their shape distortion less than 1um from their mask design into their actual shapes after etching and the shape and size of the protrusion/indentation pair substantially matches each other. In some implementations, multiple pairs of 3D alignment mark can be used. In some implementations, the thickness/depth of the pair can be from a few hundred nanometers to a few hundred micrometers. A taller protrusion and a deeper indentation feature, when matching/latching with each other, can collectively increases stability during the bonding process, but also increase the process time to form such structures. Designers have to choose a proper thickness based on their process time requirement, which is usually related to throughput, and their spec for mechanical stability. Such design choices might change the mechanical robustness of the alignment, but do not change the essential functionality of this invention. Hence, these choices are part of the "optimization" process based on the concept of this invention and should still be within the scope of this invention as long as it contains the essential elements for a protrusion/indentation pair described in the previous sections.

During the bonding process, the pair can be latched for better alignment robustness. With reference back to Fig. 11A, adding the 3D alignment mark improves the electronic IC to optoelectronic IC alignment, hence is beneficial to the overall fiber to optoelectronic IC coupling. More particularly, the optoelectronic IC 200 and the electronic IC 300 are subject to initial alignment by a bonding tool. Then the optoelectronic IC 200 and the electronic IC 300 are moved slightly in random directions (ex: by slight vibration or move in a circular way with increasing radius), until their "spacing" or "gap" is reduced, indicating that the protrusion/indentation pair 260/360 is matched and the indentation 360 is substantially filled by the protrusion 260. After such "latching" process, during the later bonding process when the pads 220/320 are in their liquid phase, the 3D alignment mark can prevent further slippery movement during the liquid phase before cooling down into the solid phase.

In practice, such 3D alignment mark feature is lithography defined and etched through the passivation layer and into the Si layer, or simply etched into the Si substrate. The etching process can be dry etch, wet etch, cycling etch, or a combination thereof. In some implementations, a protrusion structure can be done by self-assembly growth techniques such as depositing a seed on catalyst layer (ex: Al, Au) and then flow reactants (ex: SiH₄, GeH₄) on to the region with seed or catalyst so some elements (ex: Si, Ge) can react with the seed or catalyst and self-assembly grown on top of the substrate beneath the seed or catalyst. The material of the protrusion structure needs to be solvable in the catalyst or can grow on top of the seed layer. In other implementations, a protrusion structure can be done by depositing or growing a type of material which can be removed relatively easily (ex: polymer material or Ge) in case the protrusion structure can not match the indentation structure. In some implementations, the indentation structure can be done by dry etch, wet etch or their combinations.

Various implementations may have been discussed using two-dimensional cross-sections for easy description and illustration purpose. Nevertheless, the three-dimensional variations and derivations should also be included within the scope of the disclosure as long as there are corresponding two-dimensional cross-sections in the three-dimensional structures.

Thus, particular implementations have been described. Other implementations are within the scope of the following claims. For example, the actions recited in the claims may be performed in a different order and still achieve desirable results.

## Claims

1. An integrated module, comprising:
a first component (200) having a photonic device (202) and electrical pads (220) at a first side and an anti-reflection coating layer (255) at a second side opposite to the first side,
a second component (300) having electrical pads (320) at a first side and a second side opposite to the first side,
an optical signal is incident from an external medium at the second side of the first component,
wherein the first side of the first component is bonded to the first side of the second component by aligning at least one of the electrical pad (220, 320) from each component.

2. The module as in claim 1, wherein the first component (200) further includes a partially etched trench (250) opening at the second side and aligned to the photonic device (202) toward the first side and the optical signal can be coupled to the photonic device through the trench.

3. The module as in claim 1 or 2, wherein the anti-reflection coating layer (255) is between the external medium and the photonic device (202).

4. The module as in any of the claims 1 to 3, wherein a protrusion and indentation pair (260, 360) is included to form bonding between the first component and the second component.

5. The module as in any of the claims 1 to 4, wherein the photonic device (202) is a photodetector, a laser, a grating coupler, or a waveguide.

6. The module as in any of the claims 1 to 5, wherein the second component further includes a semiconductor substrate (100) or a printed circuit board.

7. The module as in any of the claims 1 to 6, wherein the second component (300) further includes a TSV (340) extended from the first side to the second side.

8. The module as in any of the claims 1 to 7, further including a third component (100) electrically connected to the module, wherein the side of the third component (100) connected to the module includes a recessed region (108) to embed at least part of the module.

9. The module as in any of the claims 1 to 8 , wherein the first component (200) is flip-chip bonded to a third component (100) consists of silicon substrate or printed circuit board.

10. The module as in any of the claims 1 to 9, wherein the second component (300) is wire-bonded or flip-chip bonded to a third component consists of silicon substrate or printed circuit board.

11. A method of forming an integrated module, comprising:
forming a surface protrusion structure and a first electrical pad on a first semiconductor substrate,
forming a surface indentation structure and a second electrical pad on a second semiconductor substrate,
disposing the first semiconductor substrate over the second semiconductor substrate by substantially matching the protrusion structure to the indentation structure and aligning the first electrical pad to the second electrical pad,
applying chemical or physical force including heating, pressure or their combination to form bonding between the first semiconductor substrate and the second semiconductor substrate.

12. The method as in claim 11, wherein the protrusion structure is formed by a self-assembly growing process with metal as the catalyst.

13. The module as in claim 11 or 12, wherein the protrusion structure or the indentation structure is formed by growing or depositing a different material than the material at the surface of the substrate.

14. The module as in any of the claims 11 to 13, wherein before applying chemical or physical force to form the bonding between the first semiconductor substrate and the second semiconductor substrate, further including a step of measuring the gap between the first semiconductor substrate and the second semiconductor substrate.

15. The module as in any of the claims 11 to 14, wherein the step of forming a surface indentation structure is done by a cycling etching process.
